## Europäisches Patentamt
## European Patent Office
## Office européen des brevets

(19)

(11) Veröffentlichungsnummer: **0 136 610**
A2

(12) **EUROPÄISCHE PATENTANMELDUNG**

(21) Anmeldenummer: **84111011.7**

(22) Anmeldetag: **14.09.84**

(51) Int. Cl.⁴: **H 01 J 49/04**
**G 01 N 23/225**

(30) Priorität: **30.09.83 DE 3335581**

(43) Veröffentlichungstag der Anmeldung:
**10.04.85 Patentblatt 85/15**

(84) Benannte Vertragsstaaten:
**AT DE FR GB NL**

(71) Anmelder: **Siemens Aktiengesellschaft**
**Berlin und München Wittelsbacherplatz 2**
**D-8000 München 2(DE)**

(72) Erfinder: **von Criegern, Rolf, Dipl.-Phys.**
**Lilienstrasse 27**
**D-8192 Geretsried(DE)**

(72) Erfinder: **Weitzel, Ingo, Dipl.-Phys.**
**Ahornring 3**
**D-8028 Taufkirchen(DE)**

(54) **Probenhalterung für Sekundärionen-Massenspektrometrie und andere empfindliche Teilchenstrahl-Analysenmethoden und Verfahren zu ihrem Betrieb.**

(57) Eine Probenhalterung für Sekundärionen-Massenspektrometrie und andere empfindliche Teilchenstrahl-Analysenmethoden soll einen weiter vereinfachten Aufbau aufweisen und damit leichter herzustellen sein. Außerdem soll das Ziel der Umgebungsfreiheit der zu analysierenden Proben (PR) in besserem Ausmaß als beim Stand der Technik realisiert werden können. Die Probenhalterung weist ein Drehteil (DT) auf, auf dem mindestens eine Trägervorrichtung (NA) befestigt ist, deren Abmessungen in Richtungen senkrecht zum Ionen- oder Teilchenstrahl (IB) kleiner sind als die Abmessungen einer auf einer Trägervorrichtung (NA) befestigten Probe (PR).

**FIG 1**

EP 0 136 610 A2

SIEMENS AKTIENGESELLSCHAFT  Unser Zeichen
Berlin und München  VPA 83 P 1822 E

0136610

Probenhalterung für die Sekundärionen-Massenspektrometrie
und andere empfindliche Teilchenstrahl-Analysenmethoden und
Verfahren zu ihrem Betrieb.

Die Erfindung betrifft eine Probenhalterung für Sekundärionen-Massenspektrometrie und andere empfindliche Teilchenstrahl-Analysenmethoden nach dem Oberbegriff des Anspruchs
1 und ein Verfahren zu ihrem Betrieb.

Bei der Technik der Sekundärionen-Massenspektrometrie (SIMS)
und bei anderen empfindlichen Teilchenstrahl-Analysenmethoden sollen störende Signaleinstreuungen, die von der Umgebung des Sputterkraters stammen, eliminiert werden.

Aufgrund der Aufgabenstellungen aus dem Bereich der Halbleiterentwicklung werden immer höhere Anforderungen an die Leistungsfähigkeit der Sekundärionen-Massenspektrometrie (SIMS)
gestellt. So soll beispielsweise die Konzentrationsspanne,
die in einem Tiefenprofil registriert werden kann ("dynamischer Bereich"), möglichst von über $10^{21}$ Atome/cm$^3$ bis unter
$10^{14}$ Atome/cm$^3$ erweitert werden, und die Nachweisgrenzen für
die interessierenden dotierwirksamen Elemente, z.B. Bor,
Antimon, sollen möglichst weit abgesenkt werden.

Bei der Sekundärionen-Massenspektrometrie (SIMS) werden die
heutigen Leistungsgrenzen bezüglich dieser beiden Kriterien
häufig durch störende Streuanteile bestimmt, die vom Rand
des bei der Messung entstehenden Sputterkraters und seiner
Umgebung stammen. Während es außerordentlich schwierig ist,
diese störenden Signalbeiträge durch apparative Maßnahmen

My 1 Bla / 15.9.1983

85 P 1822 E
0136610

noch weiter zu reduzieren, kann durch geeignete Probenpräparation ohne großen Aufwand eine beträchtliche Verbesserung erreicht werden.

Aus der europäischen Patentanmeldung EP 0 070 351 A ist
eine Probenhalterung für die Analysentechnik der Sekundärionen-Massenspektrometrie bekannt, bei der die zu analysierende Probe mit einem Ionen- oder Teilchenstrahl beschossen
wird, wobei die Probe umgebungsfrei voll im Innern des vom
Ionen- oder Teilchenstrahl getroffenen Bereiches angeordnet ist. Bei Verwendung einer solchen Probenhalterung können störende Kraterrand- und Umgebungseinflüsse weitgehend
vermieden werden.

Der vorliegenden Erfindung liegt die Aufgabe zugrunde, eine
Probenhalterung der eingangs genannten Art anzugeben, die
einen weiter vereinfachten Aufbau aufweist und damit leichter herzustellen ist unn bei der das Ziel der Umgebungsfreiheit der zu analysierenden Proben in besserem Ausmaß als
beim genannten Stand der Technik realisiert werden kann.

Diese Aufgabe wird erfindungsgemäß durch eine Probenhalterung nach dem Anspruch 1 gelöst. Ausgestaltungen und Vorteile der Erfindung sind in den Unteransprüchen, der Beschreibung und der Zeichnung angegeben.

Bei Verwendung einer erfindungsgemäßen Probenhalterung werden erstens die Proben so klein präpariert, daß sie völlig
innerhalb des vom Ionenstrahl oder Teilchenstrahl überstrichenen Bereiches liegen. Zweitens werden diese Proben in
Richtung des jeweiligen Ionen- oder Teilchenstrahles vollständung umgebungsfrei gehaltert und analysiert. Hierdurch
werden störende Kraterrand- und Umgebungseinflüsse weitgehend
eliminiert.

Durch vergleichende Messungen ist gezeigt worden, daß an vollständig umgebungsfrei präparierten Proben bei der Sekundärionen-Massenspektrometrie der dynamische Bereich der Tiefenprofile um mindestens eine Dekade erweitert wird und daß sich auch die Nachweisgrenzen für verschiedene Elemente deutlich senken lassen.

Die Verwendung einer erfindungsgemäßen Probenhalterung erfordert nur geringen präparativen Aufwand und führt bei routinemäßigen Messungen zu deutlich verbesserten Ergebnissen. Wiederholungsmessungen wegen zweifelhafter Ergebnisse können bei Verwendung einer erfindungsgemäßen Probenhalterung entfallen.

Bei einer erfindungsgemäßen Probenhalterung kommen bei Anwendung eines Ionenstrahles die Umkehrpunkte der Ionenstrahlbewegung beim Abrastern der Probe und damit der "Kraterrand" außerhalb der Grenzen der Probe zu liegen. Bei Anwendung eines Neutralteilchenstrahles kann in analoger Weise erreicht werden, daß der Rand des von diesem Neutralteilchenstrahl getroffenen Bereiches außerhalb der Grenzen der Probe liegt. Signalbeiträge aus der Umgebung der Probe werden dadurch vollständig eliminiert, daß die Probe in Richtung des Ionenstrahles oder Teilchenstrahles vollständig trägerfrei gehaltert erscheint, dadurch daß der nadelförmige Probenträger von der Probe vollständig überdeckt wird. Bei einer erfindungsgemäßen Probenhalterung können keinerlei Teilchen mehr in der Umgebung der zu analysierenden Probe auftreffen.

Ausführungsbeispiele der Erfindung sind in der Zeichnung dargestellt.

85 P 1622 E
0136610

Fig.1 zeigt ein erstes Ausführungsbeispiel der Erfindung.

Fig.2 zeigt eine Detailausgestaltung eines Ausführungsbeispieles der Erfindung.

Fig.3 zeigt ein weiteres Ausführungsbeispiel der Erfindung.

Bei der Analysentechnik der Sekundärionen-Massenspektrometrie (SIMS) wird in bekannter Weise ein Ionenstrahl IB zeilenweise über eine Probe PR gerastert und auf dieser Probe PR hierdurch ein Sputterkrater erzeugt. Die dabei entstehenden ionenförmigen Abtragungsprodukte (Sekundärionen) werden einem Massenspektrometer zugeführt und analysiert. Bei einer Registrierung der Sekundärionen-Signalintensität einer bestimmten Ionenart in Abhängigkeit von der Zeit erhält man dabei ein sogenanntes Tiefenprofil für das betreffende chemische Element bezüglich der untersuchten Probe PR.

Bei der Analysentechnik der Sekundärionen-Massenspektrometrie wird die auf ihre elementare Zusammensetzung hin zu analysierende Probe PR mit einem Ionenstrahl IB (z.B. Sauerstoff $O_2^+$, 1 bis 15 keV, 1 nA bis 10 mA) beschossen und dadurch langsam in einem Sputter-Prozeß abgetragen. Die hierbei von der Probenoberfläche freigesetzten (abgesputterten) Atome und Molekülbruchstücke können, sofern sie elektrisch geladen sind ("Sekundärionen"), in ein Massenspektrometer gelenkt, hier nach ihrem Masse-Ladungs-Verhältnis m/e getrennt und mit Hilfe eines Multipliers oder ähnlichem detektiert und gezählt werden.

Um eine gleichmäßige Abtragung der Proben PR über die zu analysierende Fläche zu erreichen , wird der Ionenstrahl IB üblicherweise auf die Probenoberfläche fokussiert und zeilenweise über die abzutragende Fläche auf der Probe PR gera-

83 P 1822 E
0136610

stert. Als Raster-Ionenstrahlgerät kann beispielsweise ein Gerät a-DIDA der Fa. Atomika GmbH, München, Bundesrepublik Deutschland, verwendet werden.

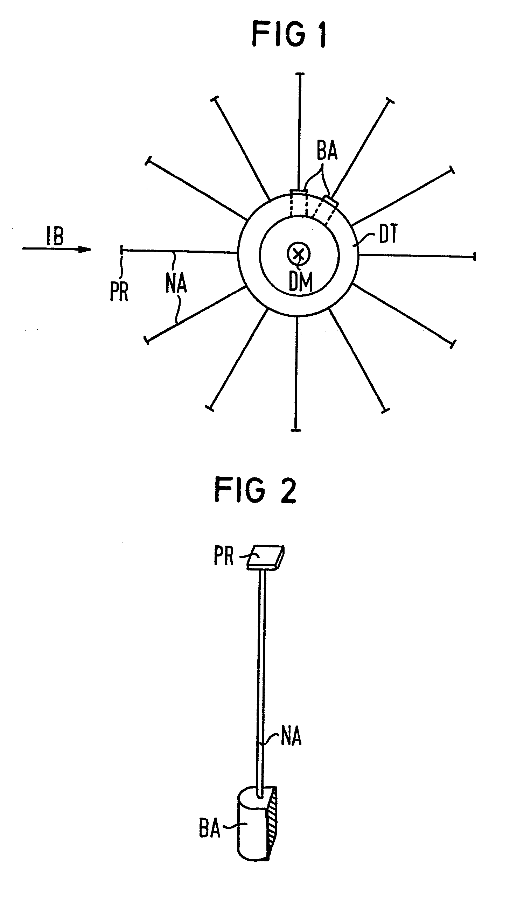

Fig.1 zeigt ein erstes Ausführungsbeispiel für eine erfindungsgemäße Probenhalterung. Die Probenhalterung besteht aus einem Drehteil DT, in das in radialer Richtung Nadeln NA eingesetzt sind, die senkrecht zur Längsachse abgeschliffen werden. Auf jeder Nadel NA wird eine kleingesägte Probe PR zur umgebungsfreien Analyse aufgeklebt. Die Oberfläche einer solchen Probe PR soll eine Länge und eine Breite von jeweils weniger als 1 mm aufweisen.

Die gesamte Probenhalterung, bestehend aus Drehteil DT mit eingesetzten Nadeln NA und aufgeklebten Proben PR wird auf der Welle DM eines handelsüblichen Ultrahochvakuum-Manipulators befestigt. Durch Drehen der gesamten Probenhalterung um die Achse DM des handelsüblichen Ultrahochvakuum-Manipulators können die einzelnen Proben PR nacheinander in die Untersuchungsposition gebracht werden, in der der Ionenstrahl IB etwa senkrecht auf die Oberfläche der Probe PR auftrifft.

Die Nadeln NA haben einen Durchmesser, der kleiner ist als die entsprechende Abmessung der kleingesägten Proben PR, so daß die Proben PR selbst diese Nadeln NA gegenüber dem Ionenstrahl IB verdecken.

Die Nadeln NA sollen möglichst lang sein, damit in Richtung des Ionenstrahles IB die nicht auf die Probenoberfläche auftreffenden Primärionen des Ionenstrahles IB erst in großer Entfernung von dieser Probenoberfläche auf eine andere Fläche auftreffen können, so daß die an dieser anderen Fläche ausgelösten Meßsignale wirklich keinen Beitrag mehr zu den im Massenspektrometer registrierten Meßsignalen liefern. Als solche Nadeln NA sind zum Beispiel insbesondere Nähnadeln mit einem Durchmesser d von weniger als 0,6 mm und einer Länge l von mindestens 5 mm geeignet. Experimente mit einer Nadellänge von 40 mm und einem Nadeldurchmesser von 0,4 mm haben sehr gute Ergebnisse geliefert. Kürzere Nadellängen bis herunter zu 1 mm sind sinnvoll bei Verwendung einer Ionenoptik zur Überführung der Sekundärionen in das Massenspektrometer.

Die Nadeln NA können in das Drehteil DT mit einer solchen Neigung versehen eingesetzt werden, daß der Ionenstrahl IB genau senkrecht auf die Probenoberfläche auftrifft. Hiermit kann die im genannten Atomika-Gerät bestehende Neigung des Ionenstrahles IB von ca. 2° gegenüber der Probennormalen ausgeglichen werden.

Fig.2 zeigt ein Ausgestaltungsdetail eines Ausführungsbeispieles der Erfindung. Jede einzelne Nadel NA ist entweder in das Einschraubstück des Drehteiles DT fest eingesetzt oder, wie in Fig.2 dargestellt, zur leichteren Probenmontage auswechselbar gehaltert. In letzterem Falle ist eine solche Ausgestaltung einer erfindungsgemäßen Probenhalterung vorgesehen, die die Lage der Nadel NA bezüglich ihres Drehwinkels um ihre Längsachse zu definieren gestattet. Zu diesem Zweck kann z.B. die Nadel NA in einer kurzen Befestigungshülse BA fest eingesetzt sein, wobei diese Befestigungshülse BA an ihrem Umfang eine Abflachung oder eine Nut besitzt. In Fig.1 sind zwei Nadeln NA gezeigt, die mittels solcher Befestigungshülsen BA so an dem Drehteil DT befestigt sind, daß die Anschlagfläche der Befestigungshülse BA am Einschraubstück des Drehteiles DT voll aufliegt. Dadurch ist die Lage der Nadel NA bezüglich ihres Drehwinkels um ihre Längsachse definiert. Damit kann sichergestellt werden, daß die Ränder der Probe parallel zum Rand des Rasterbereiches des Ionenstrahls IB liegen.

Derjenige Teil des Drehteiles DT, in den die Nadeln NA eingesetzt sind, ist von der Welle DM des Manipulators durch
mindestens ein Isolationsstück elektrisch isoliert. Auf
diese Weise können durch elektrischen Kontakt bestimmte
Potentiale bei der jeweils zu untersuchenden Probe PR
erzielt werden.

Die Anzahl der Nadeln NA und damit der Probenpositionen bei
einer erfindungsgemäßen Probenhalterung hängt sowohl von
konstruktiven Gesichtspunkten als auch von dem zu fordernden
Mindestabstand zu den Nachbarnadeln ab. Bei einem Durchmesser des gesamten "Speichenrades", das aus Drehteil DT plus
daran befestigten Nadeln NA besteht, von z.B. 120 mm, ist
eine Unterteilung dieses "Speichenrades" in Schritten von
30° geeignet.

Das Drehteil DT kann so bemessen werden, daß sich auf ihm
noch ein zweites "Speichenrad" parallel zum ersten "Speichenrad" befestigen läßt, wodurch die Anzahl der Probenpositionen verdoppelt wird.

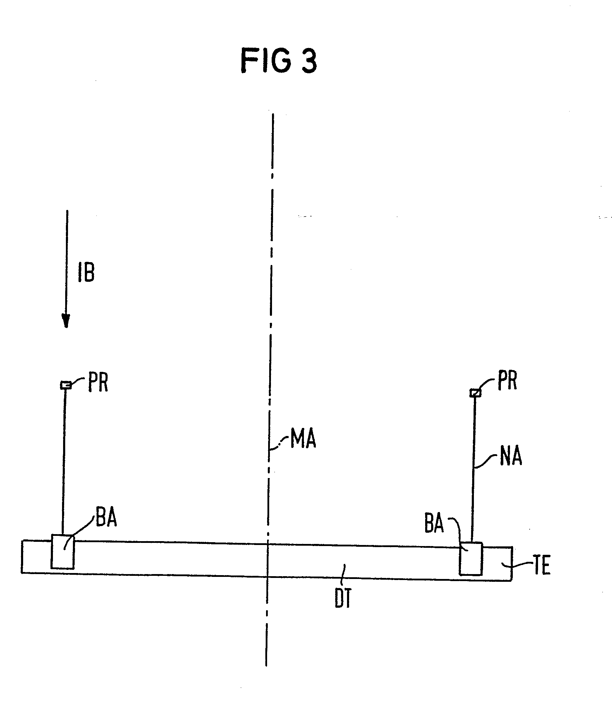

Fig.3 zeigt ein weiteres Ausführungsbeispiel der Erfindung.
Die bei den Fig.1 und 2 gemachten Angaben treffen sinngemäß
auch auf Fig.3 zu. Für solche Sekundärionen-Massenspektrometriegeräte, bei denen der Ionenstrahl IB parallel zur
Achse MA des Manipulators auf die Proben PR einfällt, zeigt
Fig.3 eine geeignete Probenhalterung. Dabei sind die Nadeln NA mittels Befestigungshülsen BA so an einem Probenteller TE befestigt, daß die Anschlagflächen der Befestigungshülsen BA am äußeren Rand des Probentellers TE fest anliegen. Auf diese Weise kann der Ionenstrahl IB wiederum senkrecht auf die Oberflächen der Proben PR auftreffen.

Grundsätzlich können bei einer erfindungsgemäßen Probenhalterung noch zusätzlich Elektroden vorgesehen werden, um Streuteilchen (Ionen, Elektronen) zurückzuhalten. Zusätzlich oder alternativ dazu können eventuell noch auftretende geringfüfige Streuanteile, die von dem Drehteil DT oder den Nadeln NA stammen, durch geeignete Wahl der Werkstoffe und/ oder durch geeignete Beschichtungen auf diesen Werkstoffen des Drehteiles DT und der Nadeln NA so klein wie möglich gehalten werden.

Patentansprüche:

1. Probenhalterung für Sekundärionen-Massenspektrometrie und andere empfindliche Teilchenstrahl-Analysenmethoden, bei der die zu analysierende Probe (PR) mit einem Ionen- oder Teilchenstrahl (IB) beschossen wird, wobei die Probe (PR) umgebungsfrei voll im Innern des vom Ionen- oder Teilchenstrahl (IB) getroffenen Bereiches angeordnet ist, g e k e n n z e i c h n e t durch ein Drehteil (DT), auf dem mindestens eine Trägervorrichtung (NA) befestigt ist, deren Abmessungen in Richtungen senkrecht zum Ionen- oder Teilchenstrahl (IB) kleiner sind als die Abmessungen einer auf einer Trägervorrichtung (NA) befestigten Probe (PR).

2. Probenhalterung nach Anspruch 1, dadurch g e k e n n - z e i c h n e t , daß mindestens eine Trägervorrichtung (NA) radial auf dem Drehteil (DT) befestigt ist.

3. Probenhalterung nach Anspruch 1 oder 2, dadurch g e - k e n n z e i c h n e t , daß mindestens eine Trägervorrich- tung (NA) eine Nadel mit einem Durchmesser d kleiner als 0,6 mm und einer Länge l von mindestens 1 mm ist.

4. Probenhalterung nach einem der Ansprüche 1 bis 3, da- durch g e k e n n z e i c h n e t , daß mindestens eine Trägervorrichtung (NA) mit einer solchen Neigung auf dem Drehteil (DT) befestigt ist, daß der Ionen- oder Teilchenstrahl (IB) genau senkrecht auf die Oberfläche der Probe (PR) auftrifft.

5. Probenhalterung nach einem der Ansprüche 1 bis 4, da- durch g e k e n n z e i c h n e t , daß mindestens eine Trägervorrichtung (NA) auswechselbar gehaltert ist.

83 P 1822 E
0136610

6. Probenhalterung nach Anspruch 5, dadurch g e k e n n -
z e i c h n e t , daß mindestens eine Trägervorrichtung (NA)
in einer Einrichtung (BA) so gehaltert ist, daß die Lage der
Trägervorrichtung (NA) bezüglich ihres Drehwinkels um ihre
Achse, die parallel zum Ionen- oder Teilchenstrahl (IB) ist,
definiert ist.

7. Probenhalterung nach einem der Ansprüche 1 bis 6, dadurch g e k e n n z e i c h n e t , daß derjenige Teil des
Drehteiles (DT), an dem mindestens eine Trägervorrichtung
(NA) befestigt ist, von der Welle (DM, MA) des Drehteiles
(DT) durch Isolationsstücke elektrisch isoliert ist.

8. Probenhalterung nach einem der Ansprüche 1 bis 7, dadurch g e k e n n z e i c h n e t , daß das Drehteil (DT)
zusammen  mit daran befestigten Trägervorrichtungen (NA)
einen Durchmesser von mindestens 10 mm und dabei etwa zwölf
Trägervorrichtungen (NA) aufweist.

9. Probenhalterung nach einem der Ansprüche 1 bis 8, dadurch g e k e n n z e i c h n e t , daß auf dem Drehteil
(DT) mindestens zwei Trägervorrichtungen (NA) in sonst beliebiger Weise so angeordnet sind, daß der Abstand der auf
ihnen befestigten Proben (PR) mindestens 1 mm beträgt.

10. Probenhalterung nach einem der Ansprüche 1 bis 9, dadurch g e k e n n z e i c h n e t , daß die Trägervorrichtungen (NA) auf dem Drehteil (DT) so angeordnet sind, daß
ihre Längsachsen parallel zur Drehteilachse (MA) sind.

11. Verfahren zum Betrieb einer Probenhalterung nach einem
der Ansprüche 1 bis 10, dadurch g e k e n n z e i c h -
n e t , daß verschiedene Proben (PR) durch Drehen des Drehteiles (DT) um die Drehteilachse (DM, MA) in die jeweilige
Untersuchungsposition gebracht werden.

1/2

FIG 1

FIG 2

FIG 3